Europäisches Patentamt

European Patent Office

Office européen des brevets

(11) Publication number: **0 065 339**
A1

# EUROPEAN PATENT APPLICATION

(21) Application number: **82200567.4**

(22) Date of filing: **11.05.82**

(51) Int. Cl.³: **G 01 J 5/46,** H 03 F 1/30,
H 03 G 3/30

(30) Priority: **20.05.81 GB 8115490**

(43) Date of publication of application: **24.11.82**
**Bulletin 82/47**

(84) Designated Contracting States: **DE FR GB SE**

(71) Applicant: **PHILIPS ELECTRONIC AND ASSOCIATED INDUSTRIES LIMITED, Arundel Great Court 8 Arundel Street, London WC2R 3DT (GB)**
(84) Designated Contracting States: **GB**

(71) Applicant: **N.V. Philips' Gloeilampenfabrieken, Groenewoudseweg 1, NL-5621 BA Eindhoven (NL)**
(84) Designated Contracting States: **DE FR SE**

(72) Inventor: **Guildford, Leslie Henry, c/o PHILIPS RESEARCH LABORATORIES, Redhill Surrey RH1 5HA (GB)**
Inventor: **Nightingale, Stephen James, c/o PHILIPS RESEARCH LABORATORIES, Redhill Surrey RH1 5HA (GB)**

(74) Representative: **Boxall, Robin John et al, Philips Electronic and Associated Ind. Ltd. Patent Department Mullard House Torrington Place, London WC1E 7HD (GB)**

(54) **Radiometer.**

(57) In a total power radiometer an amplitude modulated noise signal is injected into the radiation signal before it is mixed down to an IF frequency in a mixer (12). After the IF signal has been amplified and detected it is applied to an input of a d.c. amplifier (20) to which stabilization of channel gain and d.c. drift are applied. The gain of the amplifier (20) is stabilized by modifying the amplitude of its feedback signal using a gain control signal which is derived from the 10 kHz modulated noise signal present in the output of the amplifier (20). In the case of stabilizing the d.c. drift, the input signal to the d.c. amplifier (20) from the IF detector (18) is interrupted whilst the d.c. offset error is sampled by a capacitor which is connected to a comparator, the charge on the comparator, is compared with a reference voltage and the output is applied to an input of the amplifier (20) to correct the drift.

ACTORUM AG

"RADIOMETER"

The present invention relates to radiometers and particularly to the stabilization of channel gain in a total power radiometer.

Radiometers operating at millimetric wavelengths are used to detect natural electromagnetic radiation from objects in their field of view, the radiation having frequencies in the range from 1 GHz to 200 GHz. These objects may take the form of vegetation, animals and man-made objects, the amount of natural radiation emitted or reflected being dependent upon the "noise temperature" profile of that object. In the specific case of man-made objects it is usually the reflected radiation of the sky that is received.

The radiometer monitors a continuous broadband of radiation, similar to black body radiation. Hence the energy received from the object is roughly proportional to the bandwidth of the receiver. Therefore the sensitivity of the radiometer is related both to its bandwidth and to the signal integration time, these parameters being typically 2 GHz and 1 mS to 1 second, respectively.

The integration time becomes important when considering temporal changes in the scene which might result from relative motion or some form of scanning operation.

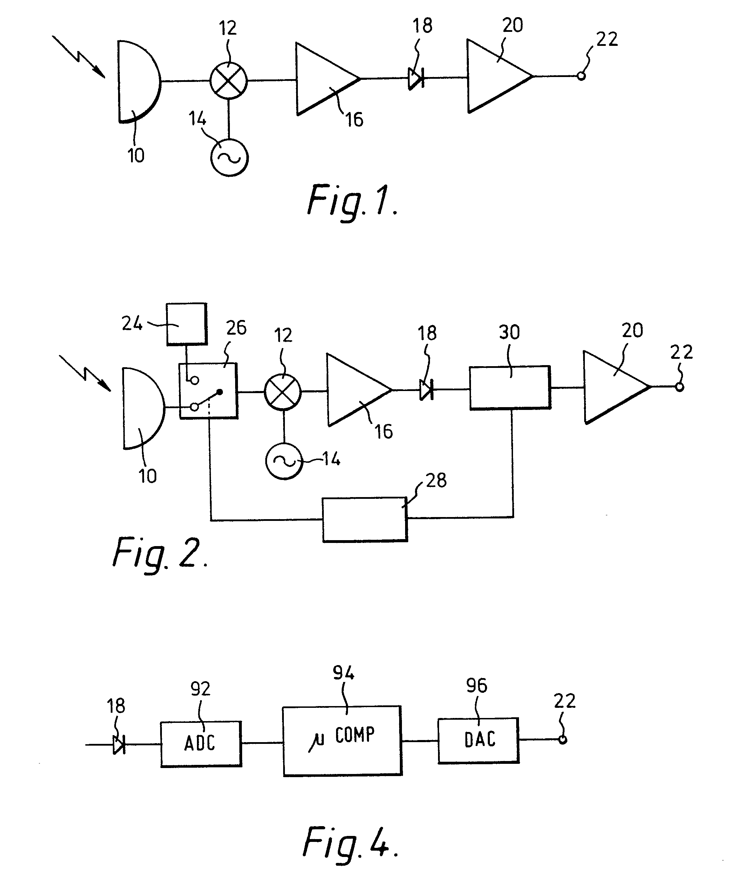

There are two well known types of radiometer which are discussed for example in Microwaves, September 1978 pages 64 to 67, 70 and 72 to 74, "Detected Noise Levels Guide Radiometer Design" by J.M. Schuchardt and J.A. Stratigos, one type is generally known as the Total Power Radiometer and is shown in Figure 1 of the accompanying drawings and the other type is the Dicke radiometer which is shown in Figure 2 of the accompanying drawings.

Referring to Figure 1, the radiometer comprises an aerial 10 which is connected to an input of a mixer 12 to another input of which a local oscillator 14 is connected. The frequency of the local oscillator 14 is such that an IF frequency of between 1 and 10 GHz is not unusual. The IF frequency is amplified in an IF amplifier 16 whose output is detected by an IF detector 18 in the form of a square-law detector. The output therefrom is amplified in a d.c. amplifier 20 and applied to an output 22 to which a data collector (not shown), for example a recorder, is connected.

Such a type of radiometer simply provides amplification and detection in an open loop system without any form of radiation reference or standardisation. Drifts in the overall gain and bandwidth affect the stability and calibration of this type of radiometer. Such drifts in sensitivity necessitate external recalibration at regular intervals.

The Dicke radiometer shown in Figure 2 aims to overcome the problem of stability by switching an internal, reference noise source 24 to the input of the mixer 12 in place of the aerial signal. The switching is carried out by a switch 26 known as the Dicke switch which operates in response to a signal produced by a switch driver 28.

The signal from the IF detector 18 is supplied to a synchronous detector 30 which derives an output to be supplied to the d.c. amplifier 20. Essentially this system provides a comparison between received radiation and that of the noise source 24. The basic system is not gain controlled and the signal that appears at the output 22 is proportional to the difference between the noise from the source 24 and the received signal from the aerial 10. Consequently variation in system gain affects the output levels and hence the calibration. This problem can be overcome if the output of the noise reference is adjusted to be equal to that of the incoming radiation, then the sensitivity of the channel affects only the ultimate resolution of the system. This adjustment is carried out by the synchronous detector detecting the difference between the two signals and using the result to adjust and equalise the output of the noise source. This is akin to nulling the signals in a bridge system and using a known value for the reference noise derived from the source 24.

The Dicke switch 26 normally operates on a 50/50 mark to space ratio. This reduces the time that radiation is available for integration by a factor of 2. In consequence either the sensitivity or the slew rate is degraded. An additional, insertion loss occurs when using a Dicke switch and the loss can amount to 3 dB.

There is an additional loss of 3 dB incurred due to the 50/50 mark to space operation of the Dicke switch which loss can be greatly reduced by increasing the radiation input period at the expense of the reference noise period. Temporal limitations such as drifts in system sensitivity and the period required for signal integration, limit the mark to space ratio and the period of the Dicke switch. However, the insertion loss due to the Dicke switch remains.

United States Patent Specification 4,272,731 discloses a gain stabilised total power radiometer in which noise is injected into a radiation signal received by an antenna and is used for gain stabilisation. The source of noise comprises a precision, stable audio frequency oscillator whose output is used to modulate a thin film microresistor reference noise generator. The radiometer includes a receiver and an audio amplifier whose gain is stabilised by separating a cyclic component primarily due to the modulated output of the reference noise generator from a d.c. component due mainly to the antenna input using a narrow band filter which is tuned to pass only signals having the same frequencies as injected by the precision stable oscillator. The separated cyclic component is compared with a fixed predetermined portion of the oscillator output to generate an output gain control voltage. The disclosed system is critically dependent on the fundamental frequency component of the oscillator to sense the gain of the radiometer system and a change in the amplitude of the fundamental frequency component causes an erroneous variation of the overall system gain so that the system loses its calibration. Consequently the system cannot tolerate noise sources such as noise diodes because their outputs unpredictably vary with ambient temperature.

It is an object of the present invention to overcome the shortcomings of the prior art radiometers.

According to the present invention there is provided a total power radiometer comprising an antenna for receiving a radiation signal, a source of an amplitude modulated noise signal having a frequency greater than the radiation signal to be detected, means for injecting the noise signal into the radiation signal, an IF stage for producing an IF signal, an IF detector and processing circuitry coupled to the IF detector and including means for producing a gain stabilised output signal, wherein the processing circuitry further comprises means for separating the amplitude modulated noise signal from the detected radiation signal, comparing means for comparing the separated noise signal with a predetermined reference signal and producing a gain control signal and means for adjusting the sensitivity of the gain stabilised output signal producing means in response to said gain control signal.

In one embodiment the processing circuitry is of analogue type and the means for producing a gain stabilised output signal comprises a d.c. amplifier having a feedback path, and the means for adjusting the sensitivity of the d.c. amplifier is coupled to the feedback path.

The means for adjusting the sensitivity of the d.c. amplifier may comprise a field effect transistor having a gate electrode coupled to an output of the comparing means and a source-drain path is connected to the feedback path of the d.c. amplifier.

The radiometer in accordance with the present invention may further comprise a first switching means connected between an IF detector for detecting the IF signal and an input of the d.c. amplifier, a d.c. drift correcting circuit coupled between an output of the d.c. amplifier and the input thereto; the drift correcting circuit including a second switching means, and logic means for controlling the first and second switching means such that when one is closed, the other is open and vice versa.

The drift correcting circuit may include a capacitor for storing the d.c. offset error sampled in response to the second switching means being closed and the first switching means being opened and a comparator for comparing the voltage on the capacitor with a reference voltage and producing a d.c. drift correcting signal which is applied to the input of the d.c. amplifier.

By the capacitor having a long time constant compared with the sampling time of the second switching means, the balance of the circuit is not upset by the gradual correction of any drift in the d.c. amplifier.

In another embodiment the processing circuitry is of digital type and includes an analogue to digital converter (ADC) for converting the detected IF signal to digital form, a programmed microcomputer coupled to the ADC and a digital to analogue converter for producing an analogue gain stabilized signal on its output.

The modulated noise signal may be injected continuously but if it is found to degrade the performance of the radiometer then it can be injected for the fractional period of time necessary to compensate for drifts in sensitivity.

The injection of the modulated noise signal may be effected by a noise radiator mounted adjoining an aerial for picking-up the radiation signal or by a directional coupler arranged in the signal path from the aerial to the mixer for mixing down the received signals to an IF signal.

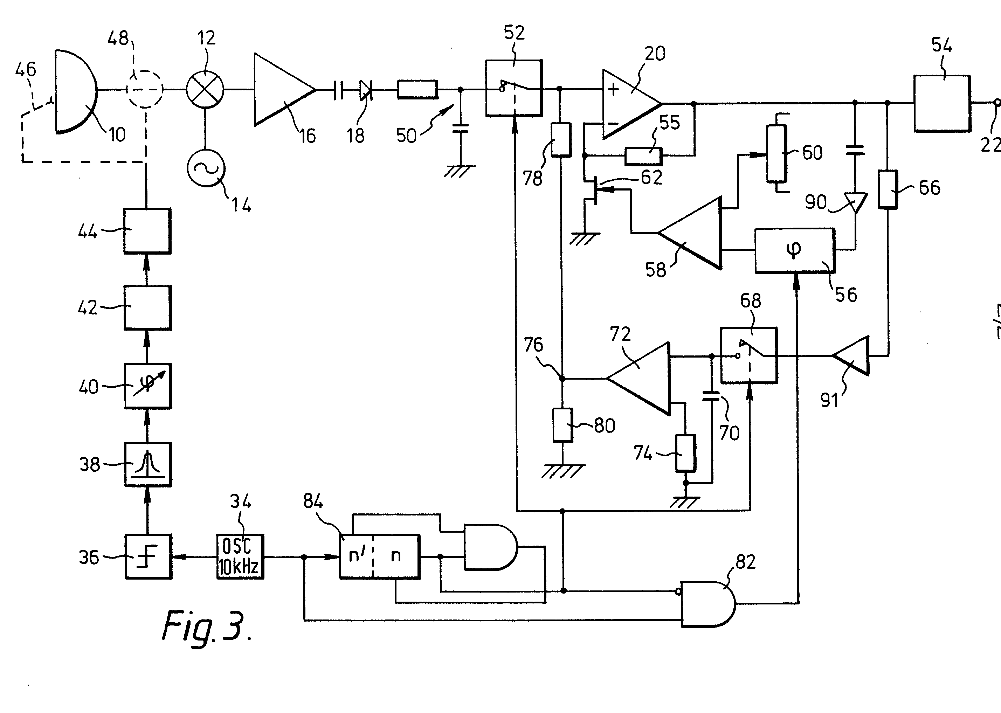

The present invention will now be described, by way of example, with reference to Figures 3 and 4 of the accompanying drawings, in which:

Figure 3 is a block schematic circuit diagram of an embodiment of an analogue stabilized radiometer system, and

Figure 4 shows a modification to the embodiment of Figure 3 in which the gain stabilization is calculated digitally. For the sake of consistency the same reference numerals have been used to identify the corresponding elements in Figures 3 and 4 as shown in Figures 1 and 2.

Referring to the circuit in Figure 3, an astable oscillator 34 generating frequency of 10 kHz has its output connected to a clipper circuit 36 which produces a square wave output whose amplitude is as constant as possible, that is within 1 or 2 millivolts, and whose phase and mark/space ratio are also kept as constant as possible. This output is filtered in a bandpass filter 38, which may comprise an active filter, to provide a 10 kHz amplitude controlled sine wave output. This signal is applied to a phase compensator 40 which is able to vary the phase of the signal by up to $360^{\circ}$. This range of phase compensation enables any delay in the overall system to be compensated. The 10 kHz signal is then applied to a bias modulator 42 after which it is amplitude modulated by means of a modulated noise source 44 in the form of a noise diode to form a low energy, broadband modulated reference noise signal. The modulated reference noise signal is injected into the continuous radiation signal to be mixed down in the mixer 12. The injection of the modulated noise signal can be effected by providing a noise radiator 46 in the signal path to the aerial 10 so that the modulated noise signal is added to the radiation received by the aerial. Alternatively the modulated noise signal can be injected into the signal path between the aerial 10 and the mixer 12 by means of a directional coupler 48. In the mixer 12 the signal is mixed down to an IF frequency of 2 GHz. The 2 GHz IF signal is applied to the IF amplifier 16 whose output is AC coupled to the IF detector 18. An integrating circuit 50 is coupled to the output of the IF detector 18, this integrating circuit 50 has a short time constant so that it can pass the signal in the range from d.c. to 10 kHz. The signal from the integrating circuit 50 is applied via an analogue switch 52 to the d.c. amplifier 20 which has a low input impedance. The amplified output from the d.c. amplifier 20 is applied to a filter circuit 54 which has a long time constant and a passband from d.c. to 1 kHz to prevent the modulated reference noise signal from appearing on the output 22. The output of the d.c. amplifier 20 is fed back via a resistor 55 to the inverting input of the amplifier 20. The signal fed back is modified by a gain control circuit formed by a phase sensitive detector 56 which is a.c. coupled to the output of the amplifier 20. An amplifier 90 is included in the signal path to the phase sensitive detector 56. The phase sensitive detector 56 is controlled by a control signal having a frequency corresponding to that of the oscillator 34, to obtain the modulated reference noise signal from the output of the amplifier 20. The signal from the phase sensitive detector 56 is compared in comparator 58 with a set gain signal derived from a potentiometer 60. The output of the comparator 58 is applied to the gate of a gain control field effect transistor 62 whose source-drain path is connected between the inverting input of the d.c. amplifier 20 and ground. As there is a $180^{\circ}$ phase difference between the gate of the transistor 62 and the inverting input of the d.c. amplifier 20 then if it is determined in the comparator 58 that the gain is too low then the feedback signal is reduced thereby increasing the amplifier's gain and conversely if the gain is too high then the feedback signal is increased thereby reducing the amplifier's gain. Varying the gain of the d.c. amplifier 20 compensates for changes in the overall channel sensitivity.

In order to reduce to a minimum the noise contribution to the amplifier 20 by the gain control circuit, the comparator 58 is given a gain of the order of unity and the gain of the amplifier 90 is the highest value possible. In consequence the comparator 58 acts as an impedance converter for noise.

In order to correct for any d.c. drift in the amplifier 20 a portion of the output thereof is tapped-off by a resistor 66 and is connected to one end of a large value capacitor 70 via an amplifier 91 and a switch 68. The capacitor 70 has a large value to provide a long time constant. The capacitor 70 is also connected to one input of a comparator 72 whose other input is connected to ground via a resistor 74. An output of the comparator 72 is connected to a junction 76 of two series connected resistors 78, 80 which are connected between the non-inverting input of the amplifier 20 and ground. As the amplifier 20 has a low input impedance the drift correcting signal could equally as well be applied to the inverting input of the amplifier 20, although account would have to be taken of the change of sign on the circuit.

The noise contribution to the amplifier 20 by the drift correction circuit is reduced by the gain of the comparator 72 being given a gain of unity and that of the amplifier 91 the highest possible value. Consequently the comparator 72 acts as an impedance converter.

In operation when the switch 52 is closed (conductive), the switch 68 is open (non-conductive) and vice versa. When the switch 68 is closed the capacitor 70 samples the d.c. offset voltage at the output of the d.c. amplifier 20, the radiation and noise signals not being present because the switch 52 is open. The sampled voltage is compared via the resistor 74 with the zero volts reference and as a result a d.c. correction signal is applied via the resistor 78 to the d.c. amplifier 20. Once the situation has reverted to normal, that is with the switch 52 closed and the switch 68 open, the charge on the capacitor 70 remains until the sampling sequence is repeated. Any correction which is necessary takes place over a number of cycles to avoid

upsetting the balance of the circuit, this is made possible
by the capacitor 70 providing a long time constant relative
to the sampling period.

In order to provide control signals for the switches 52, 68
and the phase sensitive detector 56 the output of the 10 kHz
astable oscillator 34 is applied _via_ an AND-gate 82 as a drive
signal to the phase sensitive detector 56. The other, inverting
input to the AND-gate is coupled to a counter 84 whose input
is also connected to the astable oscillator 34. The counter 84
provides an output for n' clock pulse periods, where in the
present case n' = 8 clock pulse periods (800 $\mu$S), in every
(n + n') clock pulse period, where in the present example
(n + n') equals 2054 clock pulses (205.4 mS), of the oscillator
output. The counter 84 output, when high, is used to inhibit
the drive signal to the phase sensitive detector 56 _via_ the AND-
gate 82. Simultaneously the switch 52 opens and the switch 68
closes. The effect of this switching is that the IF amplifier
16 is disconnected from the d.c. amplifier 20, the capacitor 70
samples the d.c. offset error at the output of the d.c. amplifier
20 _via_ the resistor 66 and the amplifier 91. The d.c. error
acquired by the capacitor 70 is compared with a reference
voltage, in this case zero volts, in the comparator 72, and the
output is applied as a d.c. correction signal to the non-inverting
input of the d.c. amplifier 20. After the 800 $\mu$S period, the
system reverts to normal. As mentioned above the correction
of any drift in the d.c. amplifier 20 takes a number of cycles
to reach a d.c. output of zero. By adopting this gradual approach
the balance of the circuit is not upset. A d.c. output of zero
was well maintained in conditions where the open loop gain could
vary from 0 dB to over 60 dB due to the action of the automatic
gain control system.

By the system having a common astable oscillator 34 then
any drift in its frequency does not affect the operation of the
radiometer.

In the case of comparing signals from two or more aerials
then the receiver side of the circuit is repeated. The outputs of the final filter stages are connected in pairs to a respective comparator to produce an output error signal.

Although a 10 kHz amplitude modulated reference noise signal is used in the described embodiment, any other suitable frequency may be used, the criteria being that the noise frequency is far removed from the d.c. to 1 kHz bandwidth required for the received radiation.

Furthermore although the reference noise signal in the described embodiment is a continuous modulated square or sine wave signal at 10 kHz, if it is found that the injection of this low amplitude, amplitude modulated noise signal degrades the performance of the system then it can be applied periodically. Essentially the noise signal need only be present for the fractional period of time necessary to compensate for drifts in sensitivity and its on to off ratio in such a case is determined by the estimated and acceptable drift periods and the ability of the system to "store" the signal controlling the FET 62. Such storage would have to occur at the output of the comparator 58 as an error signal or at its normal amplitude out of the phase sensitive detector 56.

In an alternative implementation of the radiometer to that shown in Figure 3 the control signals can be calculated using a microcomputer and the signals are stored digitally. The advantage of processing the signals digitally is that one is not troubled with the long time constants of an analogue circuit and drift correction in a d.c. amplifier.

A digital signal processing embodiment is shown schematically in Figure 4, the embodiment comprises an analogue to digital converter (ADC) 92 coupled to receive the output of the detector 18, a microcomputer 94 connected to the output of the ADC 92 and a digital to analogue converter (DAC) 96 connected to the output 20. As will be appreciated by those skilled in the art, the use of a microcomputer will enable other operations to be carried out such as a comparison of signals from two or more aerials.

0065339

CLAIMS:

1.    A total power radiometer comprising an antenna for receiving a radiation signal, a source of an amplitude modulated noise signal having a frequency greater than the radiation signal to be detected, means for injecting the noise signal into the radiation signal, an IF stage for producing an IF signal, an IF detector and processing circuitry coupled to the IF detector and including means for producing a gain stabilised output signal, wherein the processing circuitry further comprises means for separating the amplitude modulated noise signal from the detected radiation signal, comparing means for comparing the separated noise signal with a predetermined reference signal and producing a gain control signal and means for adjusting the sensitivity of the gain stabilised output signal producing means in response to said gain control signal.

2.    A radiometer as claimed in Claim 1, wherein the means for producing a gain stabilised output signal comprises a d.c. amplifier having a feedback path and the means for adjusting the sensitivity of the d.c. amplifier is coupled to the feedback path.

3.    A radiometer as claimed in Claim 2, wherein the means for adjusting the sensitivity of the d.c. amplifier comprises a field effect transistor having a gate electrode coupled to an output of the comparing means and a source-drain path connected to the feedback path of the d.c. amplifier.

4.    A radiometer as claimed in Claim 2 or 3, further comprising a first switching means connected between the IF detector and an input of the d.c. amplifier, a d.c. drift correcting circuit coupled between an output of the d.c. amplifier and the input thereto, the drift correcting circuit including a second switching means, and logic means for controlling the first and second switching means such that when one is closed the other is open and vice versa.

5.        A radiometer as claimed in Claim 4, wherein the drift correcting circuit includes a capacitor for storing a d.c. offset error sampled in response to the second switching means being closed and the first switching means being opened and a comparator for comparing the voltage on the capacitor with a reference voltage and producing a d.c. drift correcting signal which is applied to the input of the d.c. amplifier.

6.        A radiometer as claimed in Claim 5, wherein the capacitor has a long time constant compared with the sampling time of the second switching means.

7.        A radiometer as claimed in Claim 1, wherein the processing circuitry is of digital type and includes an analogue to digital converter (ADC) for converting the detected IF signal to digital form, a programmed microcomputer coupled to the ADC and a digital to analogue converter for producing an analogue gain stabilized signal on its output.

8.        A radiometer as claimed in any one of Claims 1 to 7, in which the modulated noise signal is injected continuously.

9.        A radiometer as claimed in any one of Claims 1 to 7, in which the modulated noise signal is injected intermittently.

Fig.1.

Fig. 2.

Fig.4.

1-II PHB 32783

Fig. 3.

0065339

**0065339**
Application number

**European Patent Office**

**EUROPEAN SEARCH REPORT**

EP 82200567.4

## DOCUMENTS CONSIDERED TO BE RELEVANT

| Category | Citation of document with indication, where appropriate, of relevant passages | Relevant to claim |
|---|---|---|
| X,P,D | US - A - 4 272 731 (DAY) <br><br> * Fig. 7; column 6, lines 29-48; column 7, line 7 - column 8, line 21 * | 1 |
| Y | | 2,3,4 |
| | -- | |
| Y | US - A - 3 679 986 (ZAMAN) <br><br> * Fig. 2; column 2, line 56 - column 3, line 68 * | 2,3 |
| | -- | |
| Y | DE - A - 2 414 829 (TELEMECANIQUE) <br><br> * Fig. 2; page 4, line 25 - page 6, line 9 * | 4 |
| | -- | |
| A,D | MICROWAVES, September 1978, <br><br> J.M. SCHUCHARDT, J.A. STRATIGOS "Detected Noise Levels Guide Radiometer Design" pages 64-74 <br><br> * Page 74, lines 29-53 * | 7 |
| | -- | |
| A | US - A - 3 693 095 (WILT) | |
| | ---- | |

**CLASSIFICATION OF THE APPLICATION (Int. Cl. 3)**

G 01 J 5/46

H 03 F 1/30

H 03 G 3/30

**TECHNICAL FIELDS SEARCHED (Int.Cl. 3)**

G 01 J 5/00

G 01 J 1/00

H 03 G 3/00

H 03 F 1/00

H 03 B 29/00

H 04 B 17/00

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims |
|---|---|

| Place of search | Date of completion of the search | Examiner |
|---|---|---|
| VIENNA | 20-08-1982 | GRONAU |

EPO Form 1503.1  06.78